# EUROPEAN PATENT APPLICATION

(11) **EP 3 758 092 A1**
(43) Date of publication of application: **30.12.2020**
(21) Application number: 20181471.2
(22) Date of filing: 22.06.2020
(51) Int. Cl.: H01M 2/10, H01M 2/16, H01M 2/20

(54) **CARRIER STRUCTURE, CELL CONTACTING SYSTEM AND MANUFACTURING METHOD**

(30) Priority: 26.06.2019 DE 102019209252
(71) Applicant: TE Connectivity Germany GmbH, 64625 Bensheim (DE)
(72) Inventor: DRESSEL, Andre Martin, 68623 Lampertheim (DE); KÄHNY, Frank, 64686 Lautertal (DE); EHEIM, Manuel, 63867 Johannesberg (DE); BLUMENSCHEIN, Rudi, 73479 Ellwangen (DE); HAPP, Jonas, 88250 Weingarten (DE); BECK, Matthias, 91555 Feuchtwangen (DE)
(74) Representative: Grünecker Patent- und Rechtsanwälte PartG mbB

(57) **Abstract**

The present invention relates to carrier structures which can be used for the electrical contacting of batteries e.g. in motor vehicles. A carrier structure (100, 400) for electrically insulating at least one first and one second electrically conductive part comprises an electrically insulating base body (102, 402), which has a first holding structure for holding the first electrically conductive part (104, 404) and a second holding structure for holding the second electrically conductive part (106), and an electrically insulating spacer (110, 210, 410), which is embedded in at least part of a separation region (108) between the first and second electrically conductive parts in the base body, wherein the spacer (110, 210, 410) has an intumescent material and/or an inorganic high temperature-resistant filler.

## Description

The present invention relates to carrier structures, which can be used in contact systems of batteries, e.g. in motor vehicles. The present invention furthermore relates to a cell contacting system, which has such a carrier structure, and to a manufacturing method.

Electrically conductive busbars which are held on electrically insulating carrier structures are usually used for the electrical contacting of batteries. These carrier structures insulate such a busbar from further electrically conductive elements, such as, for example, other busbars and contacts, metallic attachment and grounding lugs and also electrically conductive grounding plates. It has been shown that, in the event of an unusual increase in temperature (e.g. when there is a short circuit), the electrically insulating region which separates the busbar from other electrically conductive components is often not stable enough and fails. The result is an insufficient spacing between the busbar and other electrically conductive components, such that a further short circuit and even a thermal runaway of the entire battery arrangement may occur. Owing to the limited installation space and also owing to the high thermal loads when there is a fault, an increase in the wall thicknesses is often not a viable solution. Moreover, owing to the demands when there is a fault, a comparatively thick insulation made from most plastics would melt, since the melting points of conventional plastics lie in the range from 220°C to a maximum of 280°C. However, for safe electrical insulation in battery applications, for example, stability up to 500°C must be guaranteed.

There is therefore a need for carrier structures which insulate safely and reliably between electrically conductive parts even at high temperatures, but which nevertheless are able to be manufactured inexpensively and compactly.

This problem is solved by the subject-matter of the independent claims. Advantageous embodiments of the present invention are the subject of the dependent claims.

In this case, the present invention is based on the idea of providing, in at least part of an overlapping region between electrically conductive components, an electrically insulating spacer, which has an intumescent material or an inorganic high temperature-resistant filler. Depending on the installation space, a combination of the intumescent spacer with a filled insulating spacer is also possible.

If the electrically insulating spacer has an intumescent material, it changes its volume in the event of a temperature increase, which otherwise would lead to a softening of the housing material and thus to the failure of the insulation, and thus keeps the spacing between the electrically conductive components either the same or even enlarges it. As a result, it can be ensured that, in the event of a fault, there are no further short circuits. If the electrically insulating spacer is filled with a high temperature-resistant filler (such as glass, quartz or ceramic material), it remains dimensionally stable in the event of a fault and prevents the electrically conductive components from coming unacceptably close to one another.

In particular, a carrier structure, for electrically insulating at least one first and one second electrically conductive part, comprises an electrically insulating base body, which has a first holding structure for holding the electrically conductive part and a second holding structure with contact to a second electrically conductive part, and an electrically insulating spacer, which is embedded in the base body in at least part of a separation region between the first and second electrically conductive parts, wherein the spacer has an intumescent material and/or an inorganic high temperature-resistant filler.

In this case, the intumescent spacer, the insulating spacer filled with an inorganic high temperature-resistant material, or a combination of these spacers can be embedded in a base body in at least part of the separation region between the first and second electrically conductive parts.

Expansion substances such as expandable graphite, anticatalytic melamines or melamine phosphates are suitable as intumescent materials.

Advantageously therefore, without additionally increasing the wall thickness in the overlapping region between the first and second electrically insulating parts, it can be ensured that in the event of strong heating, no additional short circuits occur because the carrier material gives way. In the event of a fire, the intumescent material expands, but does not burn up. Furthermore, the intumescent material has the advantage that, in the event of a fault, it closes air gaps, which can provide too low an electrical insulation, and moreover smothers flames as a result of a lack of oxygen.

According to an advantageous embodiment of the present invention, the intumescent spacer has a crosslinked cyanoacrylate adhesive, which is filled with the intumescent material. In this case, commercially available, inexpensive adhesives can be used, which are poured as a fluid precursor into the carrier structure and are subsequently cured by UV radiation, light, heat and/or ultrasound.

A further embodiment of the invention provides a thermally and electrically insulating spacer, which draws on a crosslinked cyanoacrylate adhesive, for example, in order to reach a sufficiently high and temperature-resistant insulation in the electrically insulating base body via the addition of inorganic high temperature-resistant filler.

In order to enlarge the spacing between the first and second electrically conductive parts in a targeted way in the overlapping region, if an excessive development of heat occurs, the intumescent spacer (also without addition of acrylate adhesive) can have an at least partially intumescent piston element and a heat-resistant cylinder element, the piston element expanding inside the cylinder element under the action of heat. The cylinder element can have a ceramic material, for example, and preferably should not be electrically conductive. In this way, the intumescent spacer functions as an actuator, which moves the two conductive parts away from one another.

According to an advantageous development of the present invention, the electrically insulating spacer has glass as the filler. As a result, the electrically insulating spacer remains intact and, as long as it additionally contains an intumescent material, dimensionally stable in the expanded state. The glass grains or glass beads furthermore form a thermal and electrical insulation and prevent oxygen from reaching the combustible components of the intumescent spacer, for example an adhesive, such that the burn-up thereof is prevented or at least delayed. It is clear to a person skilled in the art that all other suitable inorganic electrically insulating and high temperature-resistant fillers, such as e.g. quartz or ceramic, can likewise be used.

In a particularly advantageous way, the electrically insulating spacer has hollow glass beads as the filler, which hollow glass beads are filled with air, for example, and thus offer an even better heat insulation.

For example, the spacer can be embedded as a lateral support element in a lattice structure of the carrier structure. In particular, the spacer can be arranged laterally between two busbars of a battery contacting system, so that in the event of overheating, air gaps and creepage paths between the busbars are maintained and filled or even the carrier structure is mechanically stabilised.

Since the intumescent material leads to a relatively strong expansion of the volume of the spacer, it may be sufficient for a secure separation of the first and second electrically conductive parts that the intumescent spacer in the non-triggered state takes up less than 50% of the overlapping region. Thus, only a small amount of space and material is required for the spacer.

According to an advantageous development of the present invention, the intumescent spacer is formed in such a way that it enlarges the spacing between the first and second electrically conductive parts by the action of heat. As a result, it can be achieved that, if required, deteriorating insulation characteristics of the housing material are compensated and in each case a short circuit between the first and second electrically conductive parts can be avoided.

Normally, however, it may also suffice to safeguard the safety spacing, which is required in order to prevent the short circuit, via the electrically insulating spacer. In this case, the insulating spacer remains intact in terms of its electrically and thermally insulating function even after strong action of heat.

According to an exemplary application environment, the first electrically conductive part is a voltage-conducting bar of a battery arrangement. By way of a spacer according to the invention, such a busbar is held separated, for example, from grounded electrically conductive parts such as a welding lug or a grounding plate. Alternatively, the separation from a further voltage-conducting busbar can also be provided.

In particular, the present invention relates to a cell contacting system of a motor vehicle battery module, in particular of an electric or hybrid vehicle, wherein the cell contacting system has a carrier structure according to the present invention and a first multiplicity of separately formed contact elements for contacting in each case two neighbouring battery cells of the motor vehicle battery module, wherein the contact elements are arranged next to one another in a first row and in each case are attached to one side of the carrier structure, furthermore comprising a second multiplicity of separately formed contact elements, which are arranged next to one another in a second row and which are provided on a side of the carrier structure opposite the first row, so that contact elements for contacting in each case two neighbouring battery cells of the motor vehicle battery module are positioned on both sides of the carrier structure.

The present invention moreover relates to a method for manufacturing a carrier structure according to the present invention, the method having the following steps:
providing the carrier structure;
introducing an electrically insulating spacer into a recess of the carrier structure, the spacer having an intumescent material and/or an inorganic high temperature-resistant filler.

A particularly simple manufacture can be achieved by the electrically insulating spacer being introduced as a flowable precursor and subsequently the flowable precursor of the electrically insulating spacer being cured.

For example, the step of curing the flowable precursor comprises the introduction of ultrasound energy. The use of ultrasound in this case has the advantage that the curing can be carried out easily even at difficult-to-access locations, particularly locations which cannot be reached by UV radiation or light. Furthermore, it can also be provided that the flowable precursor has thixotropic behaviour and the ultrasound energy is used for the short-term increase in flowability during the treatment process.

A particularly well established material is used if the flowable precursor has an acrylate-based one-component adhesive.

According to an advantageous development of the present invention, it can be provided that the electrically insulating spacer comprises an expansion substance as the intumescent material, which expansion substance is selected from the group comprising expandable graphite, melamine or mixtures thereof, and/or that the intumescent spacer furthermore comprises a filler, which is selected from the group comprising quartz particles, glass grains, glass beads and hollow glass beads or mixtures thereof.

To better understand the present invention, it is explained in greater detail with the aid of the embodiments depicted in the following figures. In this case, identical parts are indicated with the same reference symbols and the same component names. Furthermore, some features or combinations of features from the different embodiments shown and described may also constitute solutions which are independent, inventive or in accordance with the invention in their own right. In the figures:
- **Fig. 1**: shows a schematic sectional depiction of a carrier structure according to a first exemplary embodiment;
- **Fig. 2**: shows a schematic sectional depiction of a carrier structure according to a second exemplary embodiment;
- **Fig. 3**: shows a detail from Fig. 2;
- **Fig. 4**: shows a schematic detail view of a carrier structure according to a further exemplary embodiment;
- **Fig. 5**: shows a schematic perspective depiction of a carrier structure according to a further exemplary embodiment;
- **Fig. 6**: shows a plan view of the carrier structure from Fig. 5;
- **Fig. 7**: shows a schematic detail view of a carrier plate of a cell contacting system.

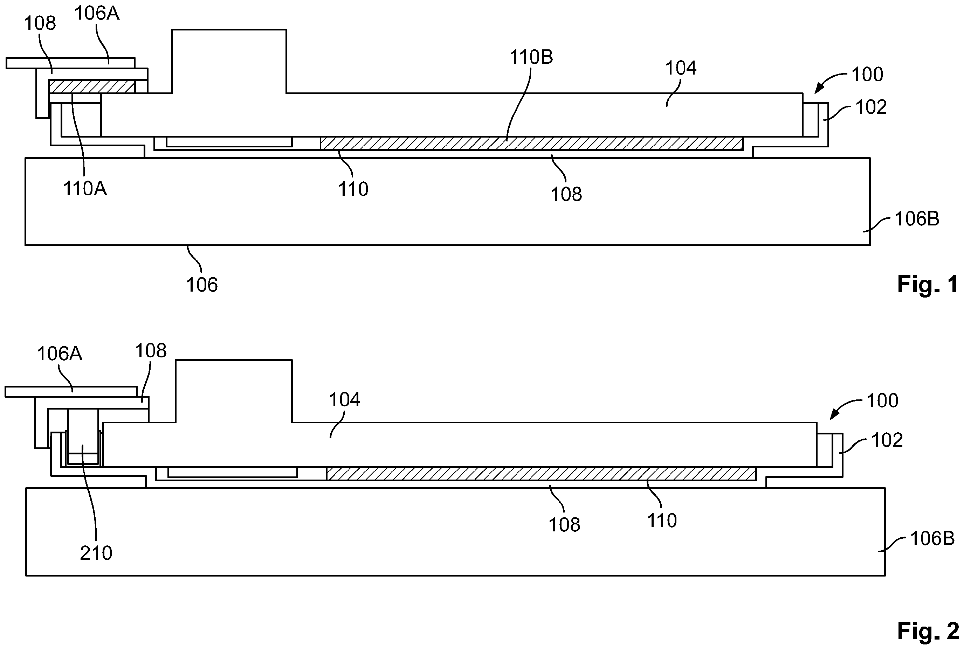

The present invention is explained in greater detail hereafter with reference to the figures, and in particular firstly with reference to the schematic sectional depictions in Figures 1 and 2. It is pointed out that, in all the figures, the size ratios and in particular the layer thickness ratios are not necessarily reproduced true to scale. Furthermore, it is obviously clear to a person skilled in the art that the principles according to the invention can be used not only in the context of battery cell contacting systems, but also for other fields of application in which electrically conductive parts insulated from one another by carrier structures are to be separated from one another reliably in the event of overheating.

Figure 1 shows, in a schematic sectional depiction, a carrier structure 100 according to the present invention, which is part of a cell contacting system.

Cell contacting systems for lithium-ion batteries comprise cell connectors and a cell holder, into which the connectors are integrated as a robust laser-welded layer construction. Alternatively, the cell connectors can also be attached to the lithium-ion cells by means of ultrasound welding or electromagnetic pulse welding (EMPT welding). Therefore, so-called "pouch cells" can also be used. The individual battery cells are connected to one another both in series and parallel to one another via the cell connectors. They take care of conduction of current, absorb cell forces and contain sensors where appropriate. The system, moreover, normally comprises a control interface with thermal and electrical monitoring.

As depicted schematically in Fig. 1, the carrier structure 100 comprises a base body 102, which is manufactured at least partially from an electrically insulating material, e.g. a plastic. A first electrically conductive part 104 is formed, for example, by a voltage-conducting busbar or a battery cell contact. A second electrically conductive part 106 furthermore comprises an electrically conductive welding tab 106A and/or a grounding plate 106B which is in contact with the base body 102 over a larger area.

Although two variants of a second electrically conductive part 106 are shown in Fig. 1, of course also only one second electrically conductive part or more than two can be present.

In order to electrically insulate the first electrically conductive part 104 and the second electrically conductive part 106 from one another, the base body 102 has separation regions 108, which are arranged in an overlapping region between the first electrically conductive part 104 and the second electrically conductive part 106. Experimental investigations on the fire performance have shown, however, that the existing separation regions 108 do not remain sufficiently stable at temperatures above 500°C to safely prevent an electrical short circuit between the first and second electrically conductive parts. The plastic of the separation region 108 frequently burned or softened so significantly that a short circuit occurred.

In order to solve this problem, the present invention provides an additional electrically insulating spacer 110 in each case in the overlapping regions between the first electrically conductive part 104 and the second electrically conductive part 106. According to the invention, the spacers 110A, 110B comprise a high temperature-resistant insulating material or an intumescent material, or alternatively a combination of high temperature-resistant inorganic material and intumescent material, which remains electrically insulating and mechanically stable, or expands, under the action of heat. Glass-like or ceramic-like fillers, which have a physically heat-resistant and electrically insulating effect, are suitable as high temperature-resistant inorganic insulating materials. Expandable graphite and melamine (2,4,6-triamino-1,3,5-triazine) and its derivatives, for example, are suitable as the intumescent fillers. As is generally known, intumescent materials are understood to be substances which, upon exposure to flames for example, foam up to form a fire-retardant, heat-resistant and electrically insulating foam from organic and/or inorganic material.

According to the invention, an acrylate adhesive which is mixed with the inorganic insulating and/or intumescent material is used as the base material. A commercially available, one-component, solvent-free isocyanate acrylate adhesive, such as can be obtained under the trade name Vitralit ® DU 8050 from Panacol-Elosol GmbH, is proven to be a particularly cost-effective embodiment. Adhesives such as this cure under UV irradiation or over longer periods under the influence of moisture.

In order to achieve an even further improved separation between the first electrically conductive part 104 and the second electrically conductive part 106, it can be provided that the cyanoacrylate adhesive is mixed with spherical glass particles, in particular with gas-filled or vacuum-filled hollow glass beads. For example, the mass can contain 60 to 90 percent by volume of glass beads.

In the event of fire, the glass beads form a thermal insulation and prevent oxygen from reaching the adhesive enclosed therein. In this way, it can be achieved that the arrangement fulfils, for example, the test provided for authorisation in the People's Republic of China, in which safe operation must be maintained for 15 minutes at 500°C.

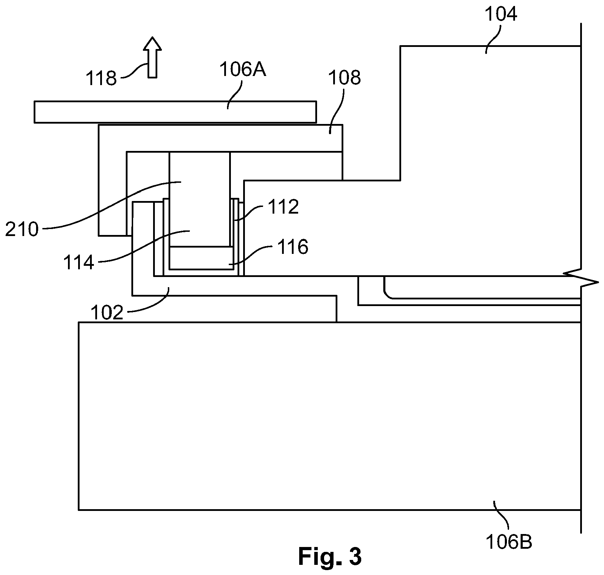

Referring to Figures 2 and 3, a further advantageous embodiment of the present invention will now be explained in detail.

The carrier structure 100 from Fig. 2 differs from the arrangement shown in Fig. 1 by way of the differently configured intumescent spacer 210. According to this alternative embodiment, the intumescent spacer 210 has an actuator function, so that in the event of fire not only is the required distance maintained, but rather the spacing between the first electrically conductive part 104 and the second electrically conductive part 106A is even enlarged further.

As can be seen in detail in Figure 3, the spacer 210 has a reciprocating piston-like structure. On the base body 102 of the carrier structure 100, a cylinder element 112 is arranged, in which a piston element 114 is located. The piston element 114 is supported on the separation region 108A of the base body 102, and can itself be intumescent or insulating. In the event of overheating, it expands and pushes the separation region 108A in the direction of the arrow 118, such that the spacing between the first electrically conductive part 104 and the second electrically conductive part 106A increases in size.

Alternatively, the piston element itself need not be intumescent, but rather can lie on an intumescent material arranged in the floor region 116 of the cylinder element 112. In this case, the intumescent material in the region 116 pushes the piston element 114 in the direction of the arrow 118, if overheating occurs. In turn, the spacing between the first electrically conductive part 104 and the second electrically conductive part 106A thus increases in size, such that a short circuit between the first electrically conductive part 104 and the second electrically conductive part 106A can be avoided.

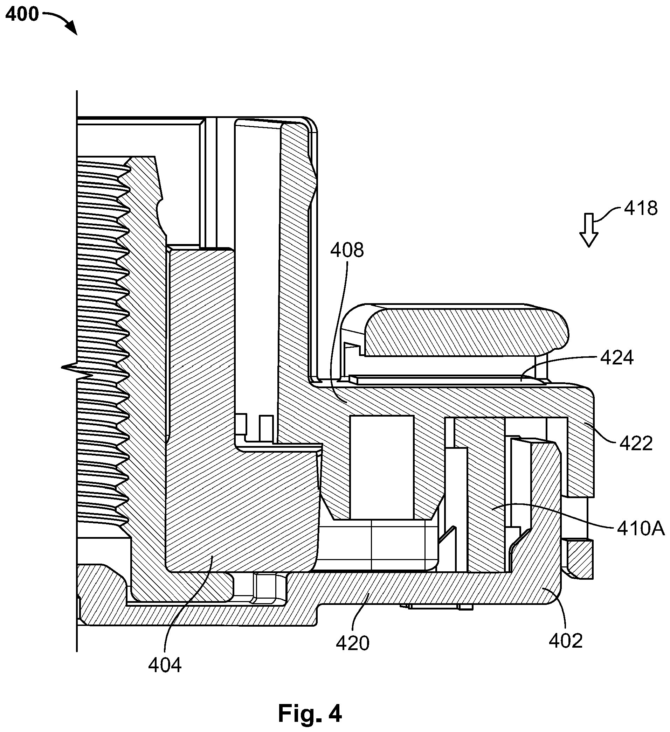

Figure 4 shows a detail view of a further advantageous configuration of the carrier structure 400 according to the invention. The base body 402 of the carrier structure 400 has a floor element 420 and a cover element 422. The first electrically conductive part 404, specifically a battery contact here, is seated in the floor element 420. The cover element 422 has a receptacle 424, into which a welding lug, not depicted in this figure, is introduced as the second electrically conductive part. During normal operation, the welding lug and the battery contact 404 are electrically insulated from one another via the separation region 408.

In order to ensure that the welding lug cannot come dangerously close to the battery contact 404 even in the event of overheating and fire, according to the invention an insulating spacer 410A is arranged between the floor element 420 and the cover element 422 in such a way that the separation region 408 holds the welding lug in its position if the insulating spacer 410A is loaded with pressure. The direction of the arrow 418 here shows the active direction of the force via the welding lug. The insulating spacer 410 shown in Fig. 4 in this case can also consist of a ceramic material.

As in the above-described embodiments, an acrylate adhesive, which is mixed with the intumescent material, is used as the base material for an intumescent spacer 410A. A commercially available, one-component, solvent-free isocyanate acrylate adhesive, such as can be obtained under the trade name Vitralit ® DU 8050 from Panacol-Elosol GmbH, is proven to be a particularly cost-effective embodiment.

In order to achieve an even further improved separation between the first electrically conductive part 104 and the second electrically conductive part 106, it can be provided that the cyanoacrylate adhesive is mixed with spherical glass particles, in particular with gas-filled or vacuum-filled hollow glass beads.

In this embodiment too (similarly to the arrangements from Figures 1 and 2) a further insulating or intumescent spacer 410B can be provided between the battery contact 404 and a second electrically conductive part, not shown here, which bears against the floor element 420. The insulating or intumescent spacer 410B is accommodated in a recess of the floor element 420 and, in the event of fire, stabilises the distance between the battery contact and the second electrically conductive part, for example a grounding plate.

The insulating or intumescent spacer 410B again is preferably manufactured from a cyanoacrylate adhesive, which is filled with a glass-like or intumescent substance such as expandable graphite or melamine or a combination of both.

The use of cyanoacrylate adhesive as the base substance for the intumescent spacer in principle also has the advantage that the adhesion to the plastics material of the carrier structure is very good, such that an exceptionally good vibration resistance can be achieved.

The second embodiment of the base body 402 as the floor element 420 and cover element 422 has the advantage that the cyanoacrylate adhesive is accessible for a UV curing before the arrangement is completely mounted.

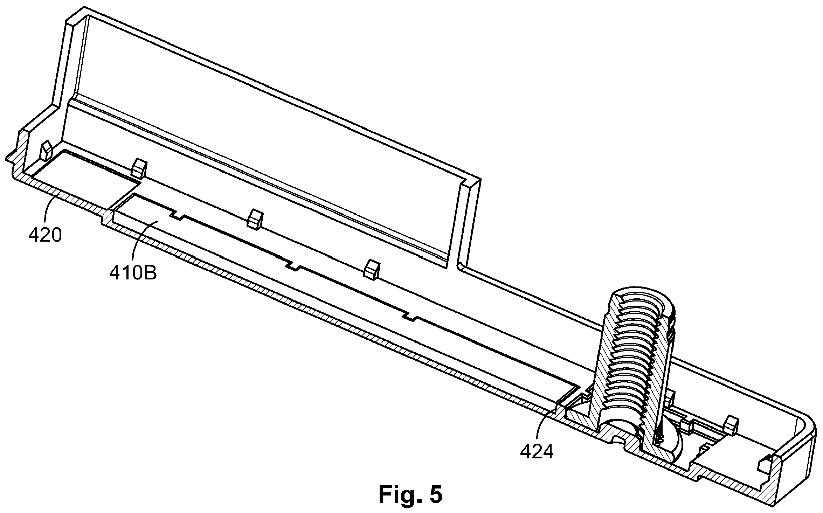

The manufacture of the carrier structure 100, 400 according to the invention will be discussed hereafter in greater detail with reference to the preceding figures. In a first step, initially the base body 102, 402 is manufactured from a plastic, for example as an injection-moulded part. As depicted in Figures 4 and 5, the base body is advantageously formed in two parts as a floor element 420 and cover element 422.

Before the floor element 420 and cover element 422 are joined together, a flowable precursor of the insulating or intumescent spacer 110, 410 is introduced into corresponding recesses, with the material being poured in through an injection nozzle, for example. However, in particular, if a glass-bead-filled cyanoacrylate adhesive is used, problems with a lack of flowability can occur when doing this. In order to increase the flowability in the injection nozzle region, the thixotropy of the cyanoacrylate adhesive can be utilised by applying ultrasound energy at this location.

The material poured into the recesses is subsequently cured by means of UV radiation or ultrasound energy.

Only then are the electrically conductive parts mounted and the entire arrangement assembled.

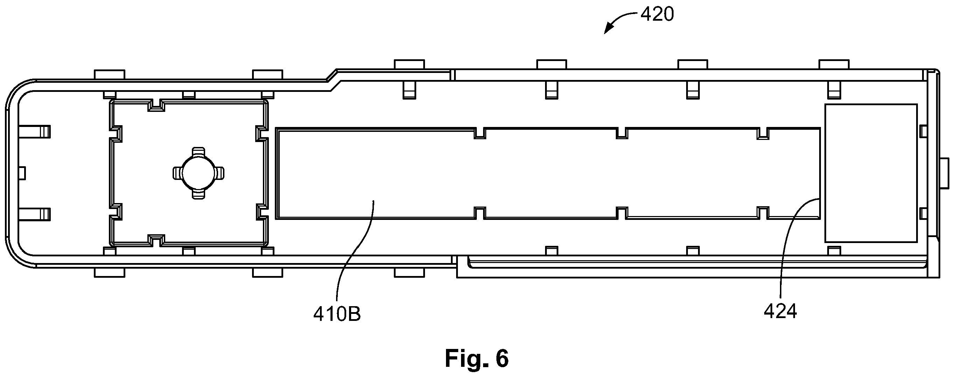

Figure 6 shows a schematic plan view of the floor element 420 from Figure 5. The electrically insulating spacer 410B is held in a corresponding flat receptacle 424 in the floor element 420. Although, in the preceding description, a method was described in which the electrically insulating spacer 410B is introduced in the form of a flowable precursor into the receptacle 424 and subsequently cured, the spacer 410B can also be inserted as a prefabricated part into the receptacle 424 and held by a press-fit, for example.

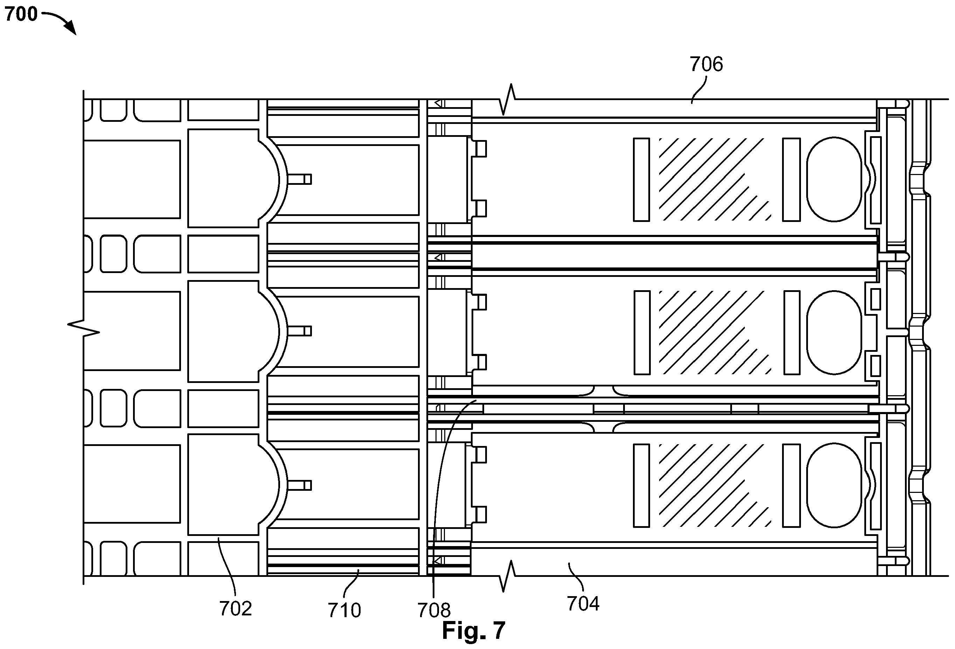

Fig. 7 shows a detail of a cell contacting system 700 for a motor vehicle battery, as a further possible application of the electrically insulating spacer according to the invention. The cell contacting system 700 has an electrically insulating base body which is configured as a frame 702. A first electrically conductive part 704 and a second electrically conductive part 706, e.g. two busbars, are fitted on this frame next to one another in one plane. In order to prevent short circuits from being formed between the first electrically conductive part 704 and the second electrically conductive part 706 in the event of overheating, according to the invention an electrically insulating spacer 710 is provided laterally. According to the invention, the electrically insulating spacer 710 is provided with an intumescent material and/or with an inorganic high heat-resistant material.

In this way, in the event of overheating, the separation region 708 can be supported reliably and the necessary electrical insulation is preserved. In particular, in the case of an intumescent filler, air gaps and creepage paths between the busbars are held and filled.

### List of reference symbols:

| **Reference numeral** | **Description** |
|---|---|
| 100, 400 | carrier structure |
| 102, 402 | base body |
| 104, 404, 704 | first electrically conductive part |
| 106, 406, 706 | second electrically conductive part |
| 108, 408, 708 | separation region |
| 110, 210 | spacer |
| 112 | cylinder element |
| 114 | piston element |
| 116 | floor region of the cylinder element |
| 118 | direction arrow |
| 420 | floor element |
| 422 | cover element |
| 424 | receptacle |
| 700 | cell contacting system |
| 702 | frame |

## Claims

1. A carrier structure for electrically insulating at least one first and one second electrically conductive part, wherein the carrier structure (100, 400) comprises:
an electrically insulating base body (102, 402), which has a first holding structure for holding the first electrically conductive part (104, 404) and a second holding structure for holding the second electrically conductive part (106), and
an electrically insulating spacer (110, 210, 410), which is embedded in the base body in at least part of a separation region (108) between the first and second electrically conductive parts, wherein the spacer (110, 210, 410) has an intumescent material and/or an inorganic high temperature-resistant filler.

2. The carrier structure according to Claim 1, wherein the electrically insulating spacer (110, 210, 410) has a crosslinked cyanoacrylate adhesive.

3. The carrier structure according to Claim 1 or 2, wherein the electrically insulating spacer (110, 210, 410) has an at least partially intumescent piston element (114) and a heat-resistant cylinder element (116), and wherein the piston element expands inside the cylinder element under the action of heat.

4. The carrier structure according to any one of the preceding claims, wherein the electrically insulating spacer (110, 210, 410) has glass, quartz and/or ceramic as the high temperature-resistant filler.

5. The carrier structure according to Claim 4, wherein the electrically insulating spacer (110, 210, 410) has hollow glass beads as the filler.

6. The carrier structure according to any one of the preceding claims, wherein the electrically insulating spacer (110, 210, 410) is embedded as a lateral support element in a lattice structure of the carrier structure.

7. The carrier structure according to any one of the preceding claims, wherein the electrically insulating spacer takes up less than 50% of the separation region (108, 408).

8. The carrier structure according to any one of the preceding claims, wherein the electrically insulating spacer (110, 210, 410) is formed in such a way that it enlarges the spacing between the first and second electrically conductive parts by the action of heat.

9. The carrier structure according to any one of the preceding claims, wherein the first electrically conductive part (104, 404) is a voltage-conducting bar of a battery arrangement, and/or wherein the second electrically conductive part (106) is a welding lug or a grounding plate.

10. A cell contacting system of a motor vehicle battery module, in particular of an electric or hybrid vehicle, wherein the cell contacting system has a carrier structure (100, 400) according to any one of Claims 1 to 9, and a first multiplicity of separately formed contact elements for contacting in each case two neighbouring battery cells of the motor vehicle battery module, wherein the contact elements are arranged next to one another in a first row and in each case are attached to one side of the carrier structure, furthermore comprising a second multiplicity of separately formed contact elements, which are arranged next to one another in a second row and which are provided on a side of the carrier structure opposite the first row, so that contact elements for contacting in each case two neighbouring battery cells of the motor vehicle battery module are positioned on both sides of the carrier structure.

11. A method for manufacturing a carrier structure according to any one of the preceding claims, wherein the method has the steps of:
providing the base body (102, 402) of the carrier structure (100, 400);
introducing at least one electrically insulating spacer (110, 210, 410) into a recess of the carrier structure, wherein the spacer (110, 210, 410) has an intumescent material and/or an inorganic high temperature-resistant filler.

12. The method according to Claim 11, wherein the electrically insulating spacer (110, 210, 410) is introduced as a flowable precursor and subsequently the flowable precursor of the electrically insulating spacer is cured.

13. The method according to Claim 12, wherein the step of curing the flowable precursor comprises the introduction of UV radiation or ultrasound energy.

14. The method according to Claim 12 or 13, wherein the flowable precursor has an acrylate-based one-component adhesive.

15. The method according to either one of Claims 13 to 14, wherein the electrically insulating spacer (110, 210, 410) comprises an expansion substance, which is selected from the group comprising expandable graphite, melamine or mixtures thereof, and/or wherein the electrically insulating spacer furthermore comprises a filler, which is selected from the group comprising quartz, glass grains, glass beads and hollow glass beads or mixtures thereof.
